# EUROPEAN PATENT APPLICATION

(11) **EP 1 168 898 A2**
(43) Date of publication of application: **02.01.2002**
(21) Application number: 01115955.5
(22) Date of filing: 29.06.2001
(51) Int. Cl.: H05K 1/18

(54) **Mobile communications device power amplifier module, mobile communications device terminal equipment and mobile communications device base station**

(30) Priority: 29.06.2000 JP 2000197222
(71) Applicant: TDK Corporation, Chiyoda-ku, Tokyo (JP)
(72) Inventor: Seawright, Stephen, Tokyo (JP); Nakai, Shinya, Tokyo (JP)
(74) Representative: Grünecker, Kinkeldey, Stockmair & Schwanhäusser Anwaltssozietät

(57) **Abstract**

To provide a mobile communications device power amplifier module, mobile communications device terminal equipment and mobile communications device base station structured in such a manner that the mounting area of mounted parts on a mother substrate can be reduced. By the elements mounted on the multilayer substrate 56 or housed in it, the transmission voltage controlled oscillator 2B and the power amplifier 17 are structured and integrated on the same substrate.

## Description

### BACKGROUND OF THE INVENTION

The present invention relates to a mobile communications device power amplifier module and a mobile communications device terminal equipment using it and a mobile communications device base station using it.

The market of a portable telephone is rapidly growing up, and the size reduction and weight reduction is strongly demanded. Further, the portable telephone also rapidly progress its function. For example, the portable telephone is connected to the internet to send an electronic mail, or a TV camera is provided to the portable telephone to enable the communication with watching the images of each other.

In this manner, in order to advance the size reduction and the reduction of the thickness while enhancing the performance , the requirement for more reduction of the size and thickness, or reduction of the number of parts, and further, the low power consumption, to the parts constituting the portable telephone, is increasing day by day.

Generally, in order to realize such the requirement, the integration of the function by an LSI as an active element, active integration, and the improvement of the performance are most important. In parallel to the development of the LSI, the integration (passive integration) of the passive parts on the periphery of the LSI including the LSI, is also important.

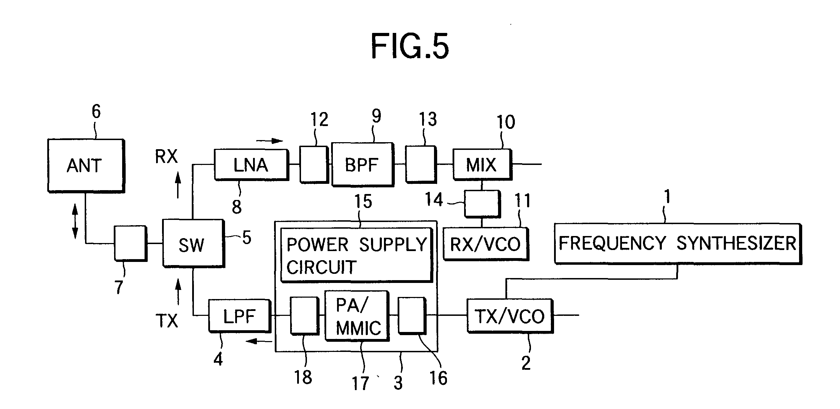

There is the same needs for the high frequencyparts (circuit parts of the transmission and reception by wireless), and the research and development are made day and night, and the requirement for the integration as described above is more increased. Relating to the status quo of such the integration, for example, an example of the high frequency circuit of the portable telephone shown in Fig. 5, is taken, and will be described below.

In Fig. 5, the arrow shows a flow of a signal, and TX means the transmission, and RX means the reception. Numeral 1 is a frequency synthesizer, numeral 2 a voltage controlled oscillator by which the digitized audio signal is modulated and the electric wave on the transmission side is produced, numeral 3 is a power amplifier module, numeral 4 is a lowpass filter as a transmission stage higher harmonic wave suppression filter, numeral 5 is a transmission and reception switching circuit, numeral 6 is an antenna, and numeral 7 is an impedance matching circuit provided between the antenna 6 and the transmission and reception switching circuit 5.

In the reception circuit, numeral 8 is a low noise amplifier, numeral 9 is a band pass filter, numeral 10 is a mixer to synthesize an intermediate frequency, numeral 11 is a reception side voltage controlled oscillator, and numerals 12 to 14 are impedance matching circuits.

The power amplifier module 3 is composed of a power source supply circuit 15, an input matching circuit 16 to conduct the input impedance matching, an output power amplifier 17, and an output matching circuit 18 by which the output impedance is set to 50 Ω.

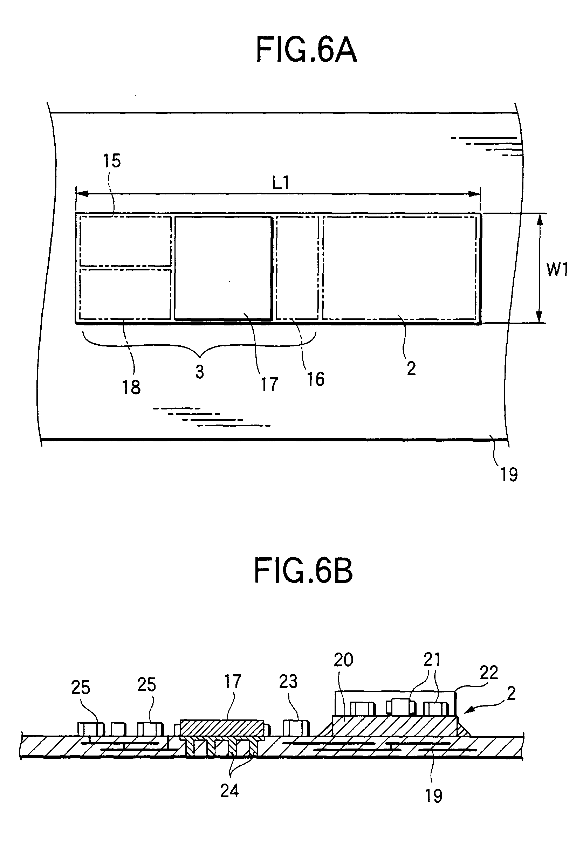

The transmission voltage controlled oscillator 2 and the power amplifier module 3 are, as shown in a plan view of Fig. 6A and a sectional view of Fig. 6B, mounted on a mother substrate 19 of the portable telephone. That is, the voltage controlled oscillator 2 is structured in such a manner that chip parts 21 are mounted on the multilayer substrate 20 having the elements, and a shield case 22 is covered on the chip parts 21. The input matching circuit 16 of the output power amplifier 17 is composed of a chip part 23 mounted on the mother substrate 19. The output power amplifier 17 is structured in such a manner that thermal bear halls 24 for the heat radiation are provided on the mother substrate 19. The power supply circuit 15 and the output matching circuit 18 are respectively structured by chip parts 25 mounted on the mother substrate 19.

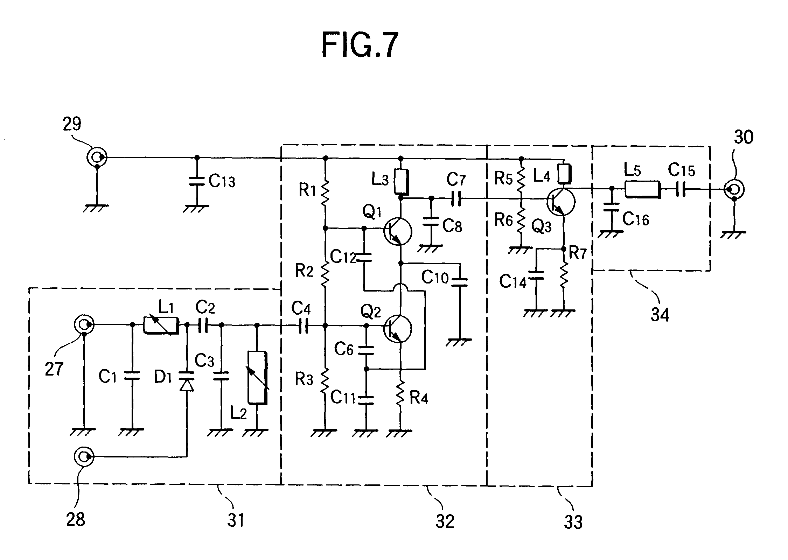

The voltage controlled oscillator 2 is structured as shown in a circuit diagram in Fig. 7. In Fig. 7, numeral 27 is a control voltage input terminal, numeral 28 is a modulation signal input terminal, numeral 29 is a power source supply terminal, and numeral 30 is an output terminal. Further, numeral 31 is a voltage variable resonance circuit, numeral 32 is an oscillation circuit and its buffer circuit, numeral 33 is an output amplifier circuit, and numeral 34 is an output matching circuit. Further, C1 to C16 are capacitors, D1 is a voltage variable capacitance diode, L1 to L5 are inductors, Q1 to Q3 are transistors, and R1 to R7 are resistance.

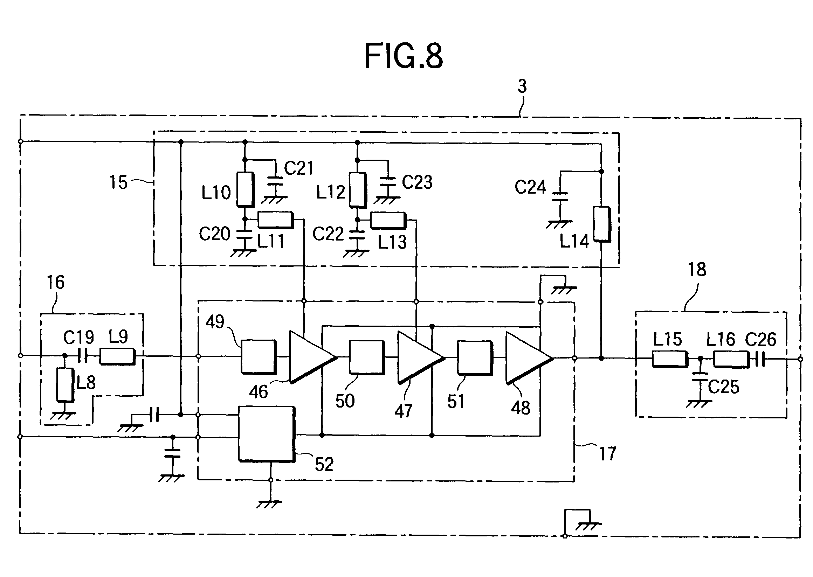

Fig. 8 is a circuit diagram of the power amplifier module 3. As shown in Fig. 8, the output power amplifier 17 is composed of amplifier circuits 46 to 48, impedance matching circuits 49, 50, and 51 of each stage, and a control circuit 52 to conduct the gain control of amplifier circuits 46 to 48.

The input matching circuit 16 is composed of inductors L8 and L9 to set the input impedance to 50 Ω, and a capacitor C19. The power supply circuit 15 is composed of inductors L10 to L14, and capacitors C20 to C24. The output matching circuit 18 is composed of inductors L15, L16 to set the output impedance to 50 Ω, and capacitors C25 and C26.

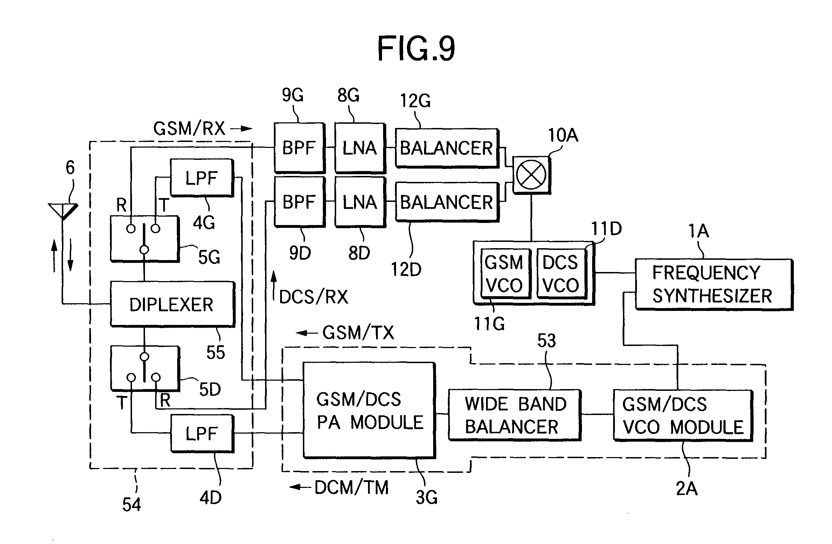

Fig. 9 is a block diagram of the conventional dual band portable telephone. This dual band portable telephone is commonly used for a GSM system (reception frequency 925 to 960 MHz, transmission frequency 880 to 915 MHz) which is one of an European portable telephone system, and a DCS system (reception frequency 1805 to 1880 MHz, transmission frequency 1710 to 1785 MHz) which is the other European portable telephone system. In Fig. 9, arrows of the GSM and its accompaniment, show the flow of the signal of the GSM system and arrows of the DCS and its accompaniment, show the flow of the signal of the DCS system. Further, TX means the transmission, and RX means the reception. Numeral 1A is a frequency synthesizing circuit, numeral 2A is a voltage controlled oscillator by which the audio signal of the GSM or DCS system is modulated, numeral 3A is the power amplifier module, numeral 53 is an impedance converter provided between both systems, and numeral 54 is a multiplex module which is a module on the antenna side.

The multiplex module 54 is composed of low pass filters 4D and 4G which are respectively transmission stage higher harmonic wave suppression filters of the GSM and DCS systems, transmission and reception switching circuits 5D and 5G, and a di-plexer 55 which is a two-frequency switching filter.

In the reception circuit, numerals 9D and 9G are band pass filters composed of elastic surface wave filters, numerals 8D and 8G are low noise amplifiers, numeral 10A is a mixer, numerals 11D and 11G are voltage controlled oscillators respectively for GSM and DCS systems, and numerals 12D and 12G are impedance conversion circuits.

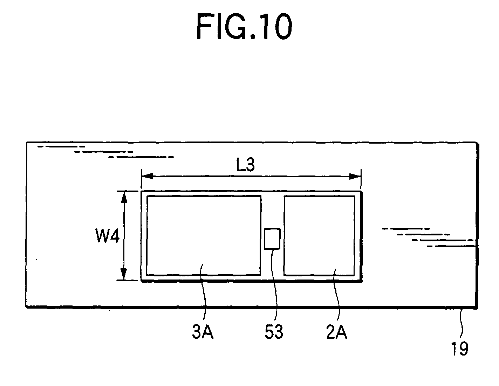

As shown in Fig. 10, the impedance converter 53 is arranged between the voltage controlled oscillator 2A and the power amplifier module 3A on the mother substrate 19.

In the conventional power amplifier module 3 shown in Fig. 6, because the power amplifier 17 and power source supply circuit 15, input matching circuit 16, and output matching circuit 18 are respectively mounted on the mother substrate 19, and further, arranged separately from the voltage controlled oscillator 2, the design work of the whole takes a lot of time period, and further, the occupation rate on the mother substrate 19 is increased.

Further, in the gain and the impedance of the power amplifier 17, because it is necessary that a power amplifier with which the guaranteed value of the output of the voltage controlled oscillator 2 and impedance are matched, is designed, there is the uselessness in the number of parts and the power consumption.

Further, in the power amplifier 17, because it is necessary to provide the bear hall 24 at the mother substrate 19 just below it for the heat radiation, the wiring or elements (strip line or inductor) can not be arranged on the mother substrate 19 just below it or in the internal layer. Thus, the occupation rate of the area on the mother substrate 19 is inevitably forced to be large.

The conventional power amplifier module 3A shown in Fig. 10 is also mounted separately from the voltage controlled oscillator 2A or the impedance converter 53 on the mother substrate 19. In the same manner as in the case of Fig. 6A, because the electric characteristics of the power amplifier module 3A and the voltage controlled oscillator are matched with each other, there is the uselessness, and the mounting area also becomes large. Further, in order to secure the shield effect of respective one of the power amplifier module 3A and the voltage controlled oscillator 2A, the shield case is mounted on each module, thereby, the number of parts and the time and cost are increased, and it also becomes a cause of the further increase of the mounting area.

### SUMMARY OF THE INVENTION

In view of the above problems, an object of the present invention is to provide a mobile communications device power amplifier module, mobile communications device terminal equipment, and mobile communications device base station, structured such that the mounting area of the mounting parts on the mother substrate can be reduced. Further, another object of the present invention is to provide the mobile communications device power amplifier module, mobile communications device terminal equipment, and mobile communications device base station, by which the mounting area can be reduced, without deteriorating the mechanical, thermal performance or electric performance.

According to first aspect of the present invention, it is provided a mobile communications device power amplifier module in that a transmission voltage controlled oscillator and a power amplifier are structured and integrated on the same substrate by elements mounted on a multilayer substrate or elements housed in it.

As described above, by structuring the power amplifier module and the transmission voltage controlled oscillator on the integrated substrate, the connection terminal can be neglected, and the mounting area is reduced, as compared to the case where these are individually mounted.

According to second aspect of the invention, in the mobile communications device power amplifier module, the output impedance of the transmission voltage controlled oscillator is matched with the input impedance of the power amplifier so that the transmission voltage controlled oscillator is directly connected the a power amplifier,

As described above, by directly connecting the power amplifier to the transmission voltage controlled oscillator, the input matching circuit of the power amplifier can be reduced, and the size can be further reduced. Further, the amplification stage of transmission voltage controlled oscillator and a plurality of amplification stages of the power amplifier are grasped as a series of amplification stage, and the gain balance can be designed again. Therefore, while securing the necessary gain, the efficiency, noise, and high frequency characteristic can be optimized.

According to third aspect of the invention, in the mobile communications device power amplifier module, a common shield case is covered onto the power amplifier and the transmission voltage controlled oscillator.

As described above, by covering the power amplifier and the transmission voltage controlled oscillator by a common shield case, the area for mounting the shield case can be minimized. Further, because the heat of the power amplifier can be released to the shield case, the upper side of the substrate just below the power amplifier and its internal layer can also be utilized for elements such as the strip line or wiring.

According to fourth aspect of the invention, it is provided a mobile communications device terminal equipment which is provided with the power amplifier module according to any one of the first aspect to the third aspect.

According to fifth aspect of the invention, it is provided a mobile communications device base station which is provided with the power amplifier module according to any one of the first aspect to the third aspect.

Because the mobile communications device terminal equipment and base station of the fourth aspect and the fifth aspect of the invention have the structure in which the power amplifier and the transmission voltage controlled oscillator are integrated, the size reduction can be attained.

### BRIEF DESCRIPTION OF THE DRAWINGS

Fig. 1A is a plan view showing the arrangement on the mother substrate of an embodiment of a power amplifier module according to the present invention, and Fig. 1B is a its sectional view;
Fig. 2 is a circuit diagram showing an embodiment of a power amplifier module main body portion in the present invention;
Fig. 3 is a circuit diagram showing an embodiment of a voltage controlled oscillator in the present invention;
Fig. 4 is a plan view showing the arrangement on the mother substrate of another embodiment of the power amplifier module according to the present invention;
Fig. 5 is a block diagram showing the structure of a high frequency circuit of the conventional portable telephone;
Fig. 6A is a plan view showing the arrangement of a transmission voltage controlled oscillator and the power amplifier module in the conventional portable telephone, and Fig. 6B is a its sectional view;
Fig. 7 is a circuit diagram of the conventional transmission voltage controlled oscillator;
Fig. 8 is a circuit diagram of the conventional power amplifier module;
Fig. 9 is a block diagram showing the structure of the high frequency circuit of the conventional dual band type portable telephone; and
Fig. 10 is a plan view showing the arrangement of the transmission voltage controlled oscillator and the power amplifier module of the conventional dual band type portable telephone.

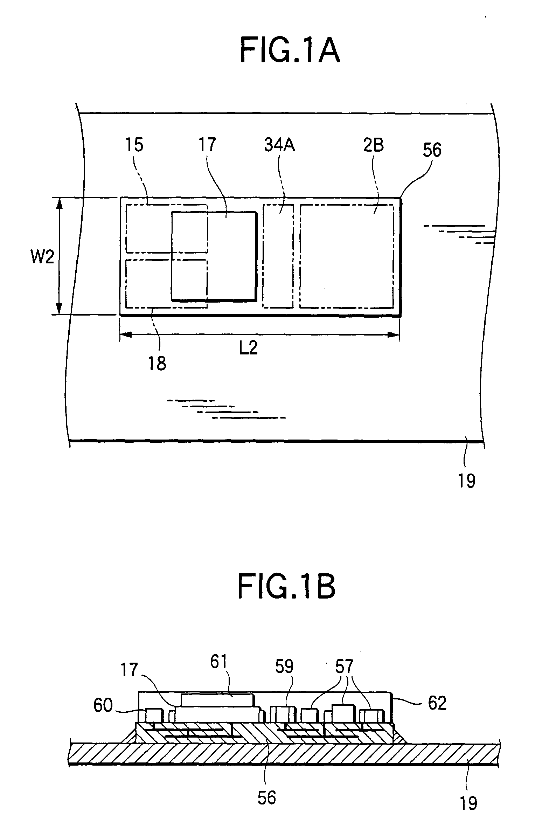

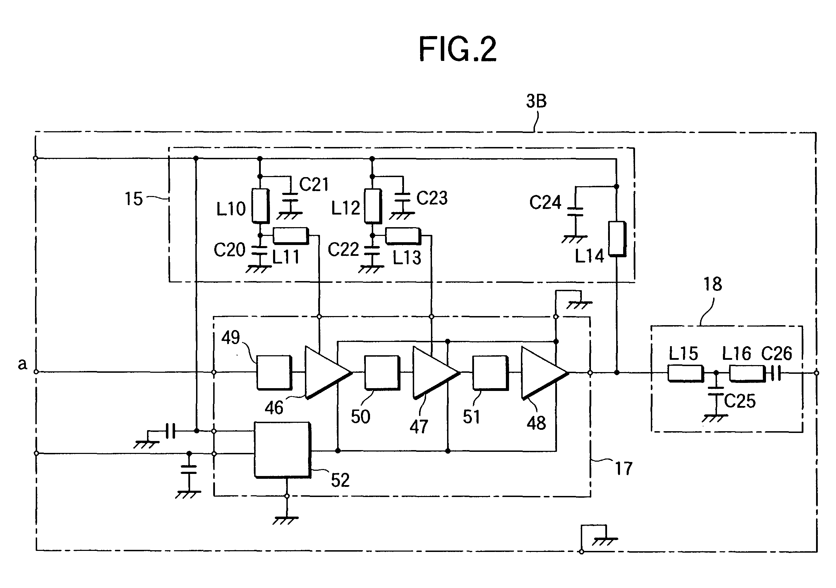

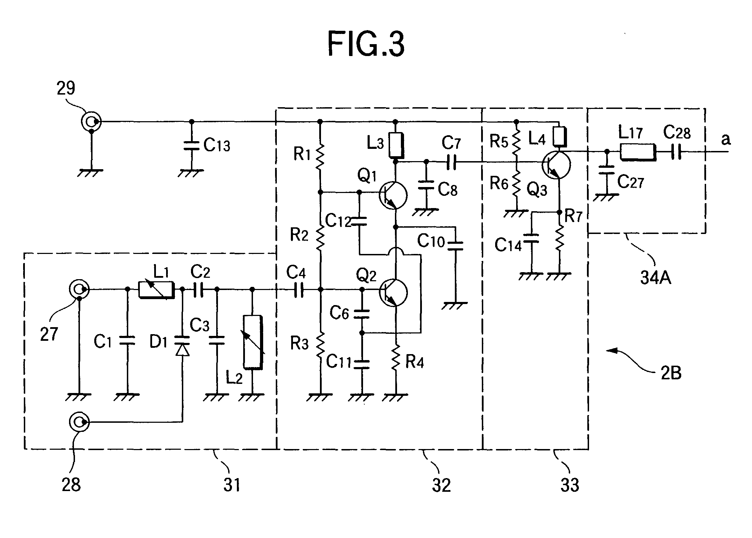

Fig. 1A is a plan view showing an embodiment of a power amplifier module of the present invention, and Fig. 1B is its sectional view. Further, Fig. 2 is a circuit diagram showing the power amplifier and its peripheral circuit of the present embodiment, and Fig. 3 is a circuit diagram of a transmission voltage controlled oscillator.

In the present embodiment, by matching the output impedance of an output matching circuit 34 of a transmission voltage controlled oscillator 2B with the input impedance (for example, about 100 Ω) of a power amplifier module main body portion 3B (that is, the output impedance is made to 100 Ω by structuring by an inductor L17 having the characteristic value different from the conventional one, and capacitors C27 and C28), an input matching circuit 16 of the power amplifier module main body portion 3B is neglected, and the power amplifier module main body portion 3B is directly connected to the transmission voltage controlled oscillator 2B.

As shown in Fig. 1A, the power amplifier 17 and the transmission voltage controlled oscillator 2B are mounted on the same multiplyer substrate 56, and the output matching circuit 34A which is a part of it, is mounted on the multilayer substrate 56 so that it is inserted as the impedance matching circuit between the both. Further, on the multilayer substrate 56, a power source supply circuit 15 of the power amplifier and the output matching circuit 18 are mounted.

In Fig. 1B, numeral 57 is an electronic part constituting the voltage controlled oscillator 2B, numeral 59 is an electronic part constituting the impedance matching circuit 34A, and numeral 60 is an electronic part constituting the power source supply circuit 15 or the output matching circuit 18. In the multilayer substrate 56, the wiring or elements necessary for the above circuit structure is structured at need.

Numeral 62 is a metallic shield case attached through a heat radiation metallic spacer 61 onto the power amplifier 17 so as to cover the mounted parts on the multilayer substrate 56.

As described above, by integrally structuring the voltage controlled oscillator 2B, power amplifier 17 and power source supply circuit 15 on the multilayer substrate 56, the terminal between the voltage controlled oscillator 2B and power amplifier 17 can be neglected, and the space saving becomes possible. Further, by neglecting the input matching circuit 16 of the power amplifier, the further space saving can be attained.

Further, when the shield case 62 is commonly used for the voltage controlled oscillator 2B and the power amplifier 17, by using the shield case 62 for heat radiation, it is not always necessary to provide a bear hall inside the multilayer substrate 56, and the strip line, or inductor or capacitor can be structured in the multilayer substrate 56. Thereby, further space saving can be attained. In this case, by interposing a metallic spacer 61 between the power amplifier 17 and the shield case 62, or by directly connecting the shield case 62 to the upper surface of the power amplifier 17, the heat radiation effect can be attained.

From these description, in the conventional structure shown in Fig. 6A, as the space occupied by the power amplifier module 3 and the transmission voltage controlled oscillator 2, a space of the longitudinal width W1 = 7.0 mm, the lateral width L1 = 27.0 mm is necessary, however, in the present embodiment shown in Fig. 1A, a space of the longitudinal width W2 = 7.0 mm, the lateral width L2 = 19.0 mm is realized, and thereby, about 30 % of occupied space can be reduced.

Further, the gain of the output amplifier circuit 33 of the voltage controlled oscillator 2B is controlled, and matched with the gains of the first, second, and third stage amplification circuits 46 to 48 of the power amplifier 17, and the gain balance as total 4 stage amplifiers is designed again, and while the necessary total gain is secured, the efficiency, noise, and high frequency characteristic can be optimized.

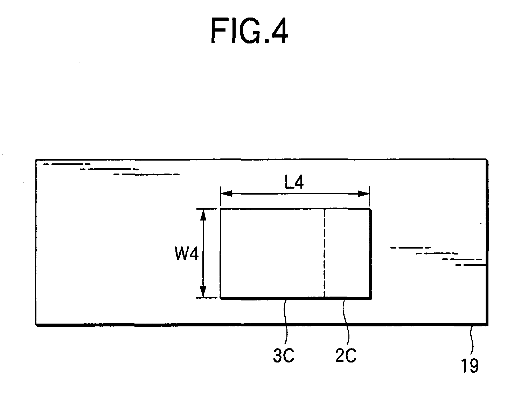

Fig. 4 shows the plane arrangement on the mother substrate 19 of the transmission voltage controlled oscillator 2C and power amplifier module main body portion 3C when the structure shown in the embodiment is applied for the dual band system mobile communications device. In the case of the dual band system, in the conventional structure shown in Fig. 10, a space of the longitudinal width W3 = 12 mm x the lateral width L3 = 30 mm is necessary, however, according to the present invention, the size of the longitudinal width W4 = 12 mm x the lateral width L4 = 21 mm is realized, and the mounting area can also be reduced by about 30 %.

The present invention is applied not only for the mobile communications device terminal equipment, but can be applied also for the mobile communications device base station for the relay. Further, the present invention can be applied not only for the case where the frequency band to be used is 2 bands, but can be applied also for the case where it is one band or more than 3 bands.

According to the first, fourth and fifth aspects of the present invention, by structuring the power amplifier module and the transmission voltage controlled oscillator on the integrated substrate, the connection terminal can be neglected, and the mounting area is reduced, as compared to the case where these are individually mounted. Accordingly, the size of the power amplifier module, mobile communications device terminal equipment, and mobile communications device base station can be reduced.

According to the second aspect, by matching the output impedance of the transmission voltage controlled oscillator with the input impedance of the power amplifier, the transmission voltage controlled oscillator is directly connected to a power amplifier, therefore, the size of the power amplifier module can be further reduced. Further, the amplification stage of transmission voltage controlled oscillator and a plurality of amplification stages of the power amplifier are grasped as a series of amplification stage, and the gain balance can be designed again. Therefore, while securing the necessary gain, the efficiency, noise, and high frequency characteristic can be optimized.

According to the third aspect, by covering the power amplifier and the transmission voltage controlled oscillator by a common shield case, the area for mounting the shield case can be minimized. Further, because the heat of the power amplifier can be released to the shield case, the upper side of the substrate just below the power amplifier and its internal layer can also be utilized for elements such as the strip line or wiring.

## Claims

1. A mobile communications device power amplifier module comprising:
a substrate; and
a multiplayer substrate formed on said substrate, having electronic elements which construct a transmission voltage controlled oscillator and a power amplifier,
wherein said transmission voltage controlled oscillator and said power amplifier are integrated on said substrate.

2. A mobile communications device power amplifier module according to Claim 1, wherein an output impedance of said transmission voltage controlled oscillator is matched with an input impedance of said power amplifier, and said transmission voltage controlled oscillator is directly connected to said power amplifier.

3. A mobile communications device power amplifier module according to Claim 1, further comprising a common shield case which covers said power amplifier and said transmission voltage controlled oscillator.

4. A mobile communications device power amplifier module according to Claim 2, further comprising a common shield case which covers said power amplifier and said transmission voltage controlled oscillator.

5. A mobile communications device terminal equipment comprising: a power amplifier module according to any one of Claim 1 to claim 4.

6. A mobile communications device base station comprising: a power amplifier module according to any one of Claim 1 to claim 4.
